# EUROPEAN PATENT SPECIFICATION

(11) **EP 1 389 747 B1**
(45) Date of publication and mention of the grant of the patent: **15.10.2008**
(21) Application number: 03077572.0
(22) Date of filing: 15.08.2003
(51) Int. Cl.: G03F 7/20

(54) **Lithographic projection apparatus and reflector asembly for use in said apparatus**
Lithographischer Projektionsapparat und Reflektoranordnung für die Verwendung in diesem Apparat
Appareil de projection lithographique et ensemble réflecteur pour l'emploi dans cet appareil

(30) Priority: 15.08.2002 EP 02078390
(43) Date of publication of application: 18.02.2004
(73) Proprietor: ASML Netherlands B.V., 5504 DR Veldhoven (NL)
(72) Inventor: Bakker, Levinus Pieter, NL-5708 ZT Helmond (NL); Jonkers, Jeroen, D-52062 Aachen (DE); Schuurmans, Frank Jeroen Pieter, NL-5551 XE Valkenswaard (NL); Visser, Hugo Matthieu, NL-3512 VK Utrecht (NL)
(74) Representative: van Westenbrugge, Andries

(56) References cited:
- EP-A- 1 211 918
- EP-A- 1 225 481
- US-A- 6 064 072
- US-B1- 6 285 737

## Description

The invention relates to a lithographic projection apparatus comprising:
- an illumination system with a radiation source, to form a projection beam of radiation,
- a support structure constructed to hold patterning means, to be irradiated by the projection beam to pattern said projection beam,
- a substrate table constructed to hold a substrate, and
- a projection system constructed and arranged to image an irradiated portion of the patterning means onto a target portion of the substrate.
   The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include;
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required; and
- A programmable LCD array. An example of such a construction is given in United States Patent US 5,229,872.As above, the support structure in this case may be embodied as a frame or table, for example, which may be fixed or movable as required. For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go: such an apparatus is commonly referred to as a wafer stepper or step-and-repeat apparatus. In an alternative apparatus ― commonly referred to as a step-and-scan apparatus ―each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In a lithographic apparatus the size of features that can be imagined onto the substrate is limited by the wavelength of the projection radiation. To produce integrated circuits with a higher density of devices, and hence higher operating speeds, it is desirable to be able to image smaller features. Whilst most current lithographic projection apparatus employ ultraviolet light generated by mercury lamps or excimer lasers, it has been proposed to use shorter wavelength radiation in the range 5 to 20 nm, especially around 13 nm. Such radiation is termed extreme ultraviolet (EUV) or soft x-ray and possible sources include, for instance, laser-produced plasma sources, discharge plasma sources, or synchrotron radiation from electron storage rings. Apparatus using discharge plasma sources are described in: W. Partlo, I. Fomenkov, R. Oliver, D. Birx, "Development of an EUV (13.5 nm) Light Source Employing a Dense Plasma Focus in Lithium Vapor", Proc. SPIE 3997, pp. 136-156 (2000); M.W. McGeoch, "Power Scaling of a Z-pinch Extreme Ultraviolet Source", Proc. SPIE 3997, pp. 861-866 (2000); W.T. Silfvast, M. Klosner, G. Shimkaveg, H. Bender, G. Kubiak, N. Fornaciari, "High-Power Plasma Discharge Source at 13.5 and 11.4 nm for EUV lithography", Proc. SPIE 3676, pp. 272-275 (1999); and K. Bergmann et al., "Highly Repetitive, Extreme Ultraviolet Radiation Source Based on a Gas-Discharge Plasma", Applied Optics, Vol. 38, pp. 5413-5417 (1999).

EUV radiation sources may require the use of a rather high partial pressure of a gas or vapor to emit EUV radiation, such as discharge plasma radiation sources referred to above. In a discharge plasma source, for instance, a discharge is created in between electrodes, and a resulting partially ionized plasma may subsequently be caused to collapse to yield a very hot plasma that emits radiation in the EUV range. The very hot plasma is quite often created in Xe, since a Xe plasma radiates in the Extreme UV (EUV) range around 13.5 nm. For an efficient EUV production, a typical pressure of 0.1 mbar is required near the electrodes to the radiation source. A drawback of having such a rather high Xe pressure is that Xe gas absorbs EUV radiation. For example, 0.1 mbar Xe transmits over 1 m only 0.3 % EUV radiation having a wavelength of 13.5 nm. It is therefore required to confine the rather high Xe pressure to a limited region around the source. To reach this, the source can be contained in its own vacuum chamber that is separated by a chamber wall from a subsequent vacuum chamber in which the collector mirror and illumination optics may be obtained.

The use of plasma sources for generating EUV radiation results in photons and (charged) particles being emitted, so-called "debris", which particles can result in a degradation of the optical components in the lithography apparatus, in particular of the illumination system. It was found that a sufficiently high gas pressure in front of the source will reduce the problem with the debris emitted from said source, but results in a drawback of too high a gas flow into the lithography system and into the EUV source.

American patent US-B1-6,285,737 discloses a condenser system comprising quasi grazing-incidence collector mirrors. The mirrors are coated with a suitable reflective material to make them particularly suitable for reflecting EUV-radiation. The combination of the position of the mirrors and the coating minimizes the effect of contaminant accumulation on the collecting mirrors. In an embodiment the backsides of the mirrors are connected to a stiffener ring to reduce the minimum thickness of the mirrors for adequate mechanical strength.

European patent application EP-A-1 225 481 discloses a reflector assembly in which a low radiation zone is formed between two adjacent mirrors.

European patent application EP-A-1 211 918 discloses a method of stopping ions and small debris in EUV- and soft x-rays plasma sources. The method employs krypton or a mixture thereof to fill the chamber of the EUV-radiation source. The method can be combined with mechanical methods for filtering debris, e.g. by using a rotating disc with a hole.

For providing EUV transparency in the illumination system, the pressure in the optical system of the illuminator is maintained relatively low, for instance at 1/1000 of the pressure of the radiation source, which may comprise Xe at a source pressure of 0.1 mbar. European patent applications EP-A-1 223 468 and EP-A-1 057 079 propose a so called foil trap structure in proximity to the source to block debris and/or to generate a pressure drop between a source chamber and an optics chamber without substantially blocking the EUV radiation path.

In the optics closer to the source, part of the incident radiation is absorbed, resulting in significant heating of the optical elements. A heating profile may result with reduced temperatures further along the optical axis. For stable and accurate operation, cooling of the optical components is necessary and a homogeneous temperature distribution is favorable for reducing temperature induced displacements in the optical system.

The optical elements in proximity to the source need to be supported in the EUV radiation beam using support structures at a position that prevents significant obstruction of the EUV projection beam.

In an embodiment, it is an object of the present invention to provide a radiation source having a debris suppression system which has relatively little impact on EUV transparency.

It is an object of the present disclosure to provide a radiation source with an illumination system comprising structural components which do not serve the purpose of imaging, that are placed in the EUV beam while causing relatively little EUV absorption.

The main object is achieved according to the present invention by a reflector assembly as defined by claim 1.

The reflector assembly functions as a collector of EUV radiation emitted by the source and directs a collimated beam of EUV radiation focused in the intermediate focus to further optical components along an optical axis to form the projection beam. Depending on the distance from the optical axis and the mutual distance between the two reflectors, a specific spatial segment of the projection beam, with the source as a center, is intercepted. Between the two reflectors the radiation propagates by being reflected at grazing angles off the reflective surface of the upper reflector. The space occupied by the reflected rays between the reflectors is defined by the rays emanating from the source and being intercepted by the entry parts of the reflectors. These rays bound zones generally being rotionally symmetric around the optical axis of low radiation intensity in which the structural objects of the present invention are placed, preferably supported on the backing surface of the reflector closest to the optical axis.

By providing a structure in specific positions within the EUV beam, it was found that no substantial radiation absorption was introduced when the positions are selected to correspond to the low intensity regions.

In one embodiment, the reflectors extend at an angle to the optical axis. Each reflector may comprise at least two adjacent reflecting surfaces, the reflecting surfaces further from the source being placed at the smaller angle to the optical axis than the reflecting surface is closer to the source. In this way, a grazing incidence collector may be constructed for generating a beam of EUV radiation propagating along the optical axis. Preferably, at least two reflectors are placed substantially coaxially and extend substantially rotationally symmetric around the optical axis. A grazing incidence collector of this (Wolter-) type is, for instance, described in German patent application no. DE 101 38 284.7.

In one embodiment, said nozzle comprises at least one fluid supply means for directing a fluid in the direction of the source. In this way, a buffer gas at relatively high pressure and low gas volume can be directed towards the source for removal of debris emitted by the source. With the system of the present invention, a high pressure and low gas load can be obtained. Preferably, the gas used is substantially transparent to EUV radiation and may be formed of He, Ar, N₂, H₂. Near the entry side of the reflector, a fluid removal unit, such as a pump, may be situated for removal of the gas and for preventing the gas from reaching the EUV source. The reflectors may be placed in a chamber having an opening comprising a pressure reduction member, such as a foil trap referred to earlier, the radiation source being placed in an adjacent source housing and emitting radiation through the pressure reduction member, the fluid removal unit being located in the chamber for removing fluid near the pressure reduction member, a second fluid removal unit being connected to the source housing.

In an example, the flow resistance of the reflector assembly is increased by placing a gas barrier member in the low intensity regions. Hereby the reflector assembly may form an effective vacuum separation between a source side and the optical components downstream of the optical axis, allowing removal of gas at a downstream side at relatively low pumping rates. The gas barrier may be formed by plate-shaped members that may be placed perpendicular to the backing surface of the reflector within the low intensity regions for increasing pressure resistance across the reflector along the optical axis. Pressure reduction may also be achieved by placing a barrier in the low intensity regions having a cross-section substantially corresponding to the boundaries of the low intensity zone. In this way, the gas flow rate through the collector can be reduced by approximately a factor of 2.

In an example, within heat transfer means, such as fluid ducts or heat-conducting elements, such as copper wires are placed within the low intensity zones. The ducts or copper wires may be guided away from the reflectors through the low intensity regions and be connected to a heat exchange element at the distance from the optical axis, such as an adjustable heat sink. By varying the diameter of the heat conductors, or by varying the heat conductor density in the direction of the optical axis, a differential heating or cooling along the optical axis may be achieved.

According to another example, transducers may be included within the low intensity regions for generating measurement signals, such as thermocouples, pressure sensors, or other structures, without affecting the EUV intensity of the generated beam.

Another possibility is to include mechanical or electrical-mechanical actuators for loyally adjusting the reflector surface with respect to the optical axis. The invention also relates to a radiation system as claimed in claim 9 and a lithographic apparatus as claimed in claim 10. The invention also relates to a method of manufacturing an integrated structure by a lithographic process as defined in claim 11.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
Fig. 1 schematically depicts a lithographic projection apparatus according to an embodiment of the invention;
Fig. 2 shows a side view of an EUV illumination system and projection optics of a lithographic projection apparatus according to fig. 1;
Fig. 3 shows a detail of the radiation source and grazing incidence collector of the present invention;
Fig. 4 shows a schematic view of the low radiation intensity zones in a grazing angle reflector assembly according to fig.3;
Fig. 5 shows a perspective view on the grazing incidence collector of Fig. 3.;
Fig. 6 shows a gas injection system incorporated in the grazing incidence collector of Fig. 3;
Fig. 7 shows a gas barrier system associated with the grazing incidence collector of Fig. 3;
Fig. 8 shows cooling ducts associated with the grazing incidence collector of Fig. 3;
Fig. 9 shows conductive elements and a transducer and/or actuator associated with the graying incidence collector of Fig. 3; and
Fig. 10 shows a support frame for the components of the grazing incidence collector of Fig. 3 according to the present invention.

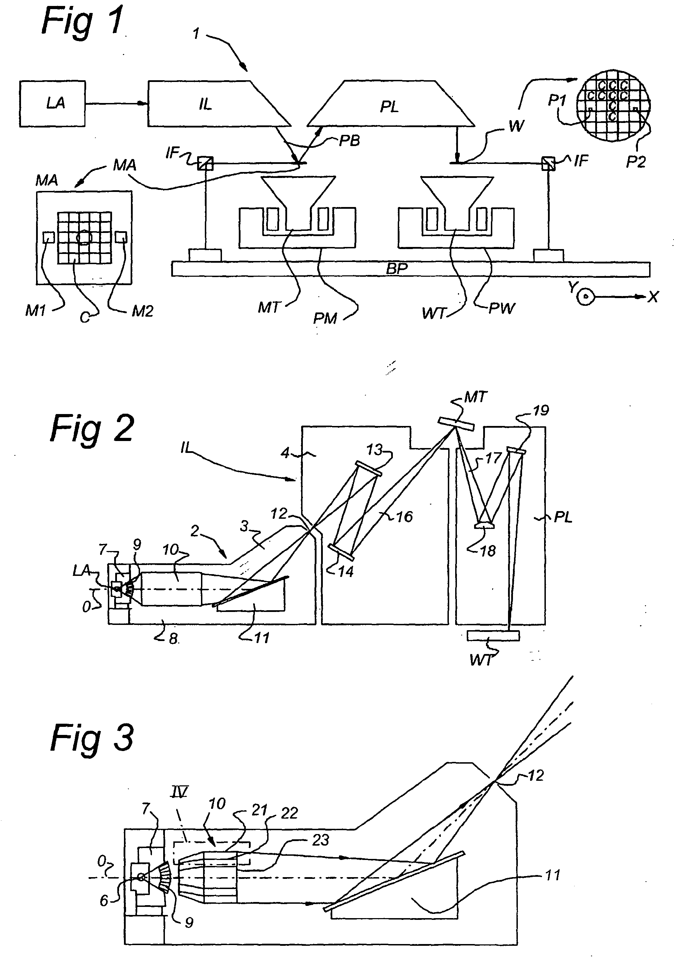

Fig. 1 schematically depicts a lithographic projection apparatus 1 according to a particular embodiment of the invention. The apparatus comprises:
- a radiation system Ex, IL, for supplying a projection beam PB of radiation (e.g. EUV radiation) with a wavelength of 11-14 nm. In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W. As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above

The source LA (e.g. a laser-produced plasma or a discharge plasma EUV radiation source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam, In addition, it will generally comprise various other components, such as an integrator IN and a condenser CO. In this way, the beam PB impinging on the mask MA has a desired uniformity and intensity distribution in its cross-section.

It should be noted with regard to Fig. 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V - Mv, in which M is the magnification of the lens PL (typically, M = 1/4 or 1/5). In this manner, a relatively large target portion C can be exposed, without having to compromise on resolution.

Fig. 2 shows the projection apparatus 1 comprising an illumination system IL with radiation unit 3, illumination optics unit 4, and projection optics system PL. The radiation system 2 comprises a source-collector module or radiation unit 3 and an illumination optics unit 4. Radiation unit 3 is provided with a radiation source LA which may be formed by a discharge plasma. EUV radiation source 6 may employ a gas or vapor, such as Xe gas or Li vapor in which a very hot plasma may be created to emit radiation in the EUV range of the electromagnetic spectrum. The very hot plasma is created by causing a partially ionized plasma of an electrical discharge to collapse onto the optical axis O. Partial pressures of 0.1 mbar of Xe, Li vapor or any other suitable gas or vapor may be required for efficient generation of the radiation. The radiation emitted by radiation source LA is passed from the source chamber 7 into collector chamber 8 via a gas barrier structure or "foil trap" 9. The gas barrier structure comprises a channel structure such as, for instance, described in detail in European patent applications EP-A-1 223 468 and EP-A-1 057 079, which is incorporated herein by reference.

The collector chamber 8 comprises a radiation collector 10 which according to the present invention is formed by a grazing incidence collector. Radiation passed by collector 10 is reflected off a grating spectral filter 11 to be focused in a virtual source point 12 at an aperture in the collector chamber 8. From chamber 8, the projection beam 16 is reflected in illumination optics unit 4 via normal incidence reflectors 13, 14 onto a reticle or mask positioned on reticle or mask table MT. A patterned beam 17 is formed which is imaged in projection optics system PL via reflective elements 18, 19 onto wafer stage or substrate table WT. More elements than shown may generally be present in illumination optics unit 4 and projection system PL.

As can be seen in Fig. 3, the grazing incidence collector 10 comprises a number of nested reflector elements 21, 22, 23. A grazing incidence collector of this type is, for instance, shown in German patent application DE 101 38 284.7.

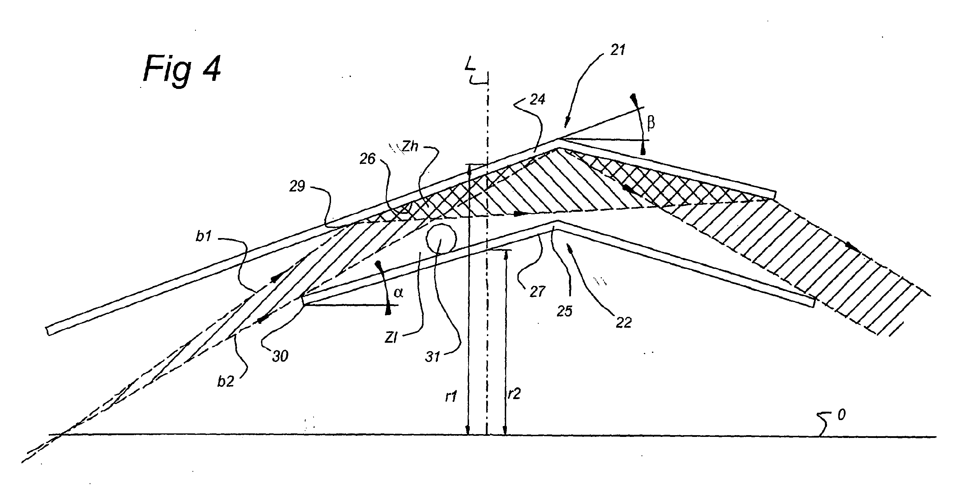

It the schematic overview of Fig. 4, an enlarged detail of the two (nested) adjacent reflectors 21, 22 of grazing incidence collector 10 of fig. 3 are shown. Each reflector comprises a backing surface 24, 25 and a reflective surface 26, 27. Reflector 22 is located at a distance r2 from the optical axis, which is smaller than the distance r1 from the optical axis to reflector 21. The distances r2 and r1 may for instance comprise 20 respectively 80 mm. The reflectors 21 ,22 are under an angle α respectively β with the optical axis O at r1 and r2 resprctively. The reflectors 21, 22 may be curved i.e. the angles α and β with respect to the optical axis O may vary along the optical axis O. Rays of radiation b1 and b2 emitted from the source 6 and being reflected by entry sections 29, 30 of reflectors 21, 22 are reflected off reflective surface 26 of top reflector 21 and define zones zh of radiation intensity in the space between reflectors 21, 22 and zones zl of low or zero radiation intensity. Zones zl are of substantial triangular cross-section and are substantially free of radiation. This allows structures 31, such as explained in detail hereafter, to be attached to backing surface 25 of reflector 22 such as to be situated in the space between reflectors 21, 22 without causing substantial absorption of radiation.

It should be noted that the backing surfaces 24, 25 may be absorptive for radiation or, if so desired, reflective.

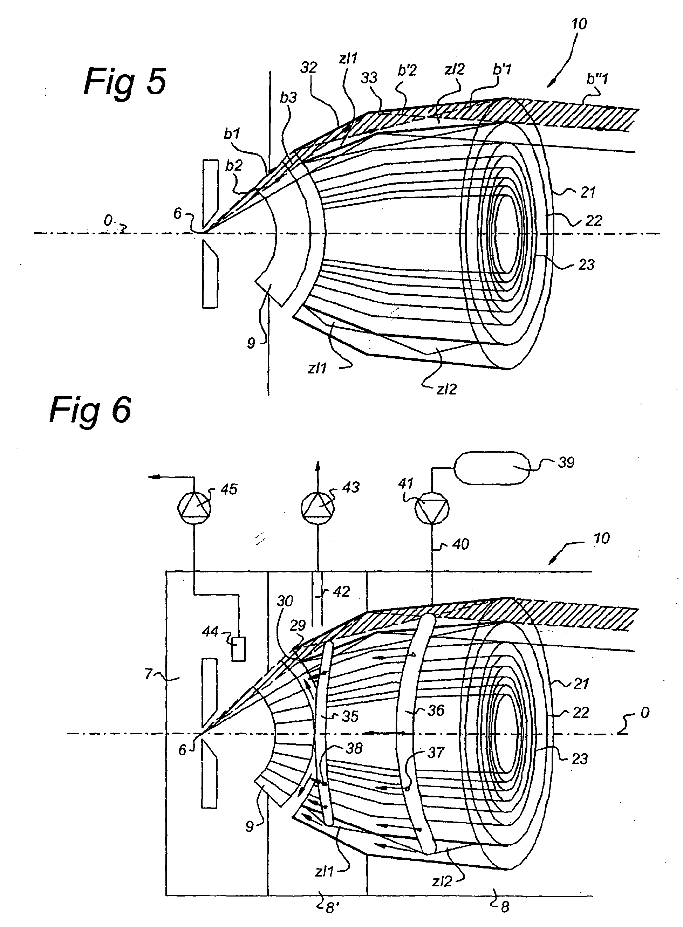

Fig. 5 shows a perspective view of a grazing incidence reflector 10 comprising eight coaxially nested reflectors. Each reflector 21,22 may comprise a first reflector surface 32 and second reflector surface 33 at an angle to reflecting surface 32. Also, there may be a smooth transition from first reflecting surface 32 to second reflecting surface 33. Incoming ray b1 is reflected off reflector 32 as ray b'1 and reflected off reflector 33 as ray b''1. Incoming ray b2 is reflected off reflector 32 as reflected ray b2, rays b"1 and b2 leaving the collector and forming an annular radiation beam situated around optical axis O. Rays b2 and b'1 form boundary rays of first low radiation intensity zone z11, whereas reflected ray b'1 and b'2 form boundary rays of second low intensity zone z12. Low intensity zones z11, z12 are rotationally symmetric about optical axis O. The shaded area in Fig. 5 defines the high radiation intensity zones between reflectors 21, 22.

Fig. 6 shows an embodiment wherein the grazing incidence collector 10 in the low intensity zones z11, z12 is provided with gas injection members 35, 36. Gas injection members may be tubes placed on the backing surfaces of the reflectors which tubes comprise openings or nozzles 37, 38 for supplying a gas in the space between adjacent reflectors in the direction of the source 6. The gas may be introduced into the tubes 35, 36 from a gas supply reservoir 39, via fluid duct 40 and pumping unit 41. The gas comprises preferably an EUV transparent gas such as He, Ar, N₂, H₂ which is supplied at a gas flow rate in between 0 an 1000 mbar*litres/second. The gas stream will be substantially blocked by the foil trap 9 and will travel along the surface thereof in the directions of the arrow as indicated, and may be removed via a gas removal duct 42 and exhaust pump 43. Particles and other impurities deriving from the source 6 and travelling through the foil trap 9 will be removed by the gas stream via gas removal duct 42 without being able to travel through grazing incidence collector 10 into the projection optics unit 5. Hence, damage to projection optics can be strongly reduced. By using a gas flow at a rate in between 0 an 1000 mbar*litres/second removal can be achieved while maintaining the gas flow into the source 6 at a low level. By being able to place the gas injection members 35, 36 in very close proximity to the ray paths of the radiation transmitted through grazing incidence collector 10, without substantially blocking EUV transmission and opposite to the main propagation direction of the debris, the gas flow can be directed substantially in the directions of the EUV photons without blocking these. A second gas removal duct 44 may be placed within source chamber 7 for removing any residual gas flow deriving from gas injection members 35, 36 at the back of foil trap 9 via exhaust pump 45.

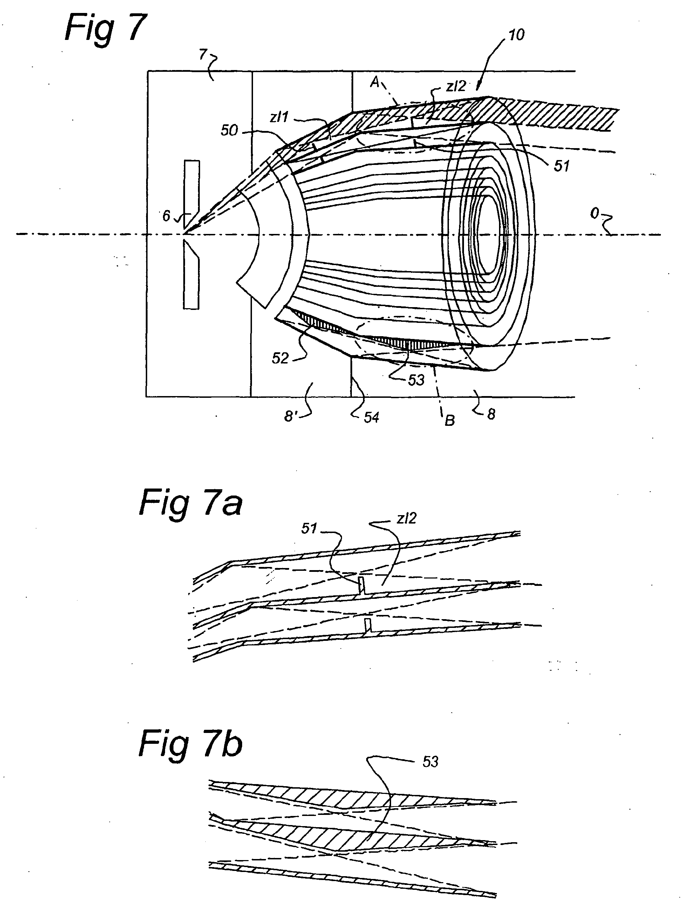

Fig. 7 shows a grazing incidence collector 10 in which gas barrier members 50, 51 or 52, 53 are connected to the backing surface of the inner reflectors in low intensity zones z11, z12, For the collector parts situated above the optical axis, the gas barrier members 50, 51 are indicated to be formed of annular, plate-shaped members substantially perpendicular to the reflectors and extending to substantially halfway the distance between adjacent reflectors, i.e. to the top of low intensity zones z11, z12, In the lower parts of grazing incidence collector 10, the gas barrier members 52, 53 are shown to be comprised of three dimensional ring-shaped gas barrier members with triangular cross-section for providing even more effective blocking of a gas flow along the reflectors towards the projection optics. Using this construction, a high pressure difference between source chamber 7 and illuminator optics chamber parts 8' can be effected, the pressure in source chamber 7 being for instance 0.1 mbar whereas pressure in illuminator optics chamber 8' are 0.001 mbar. A partitioning wall 54 sealingly closes off chamber 8' from illuminator optics chamber 8 such that a pressure difference between chambers 8' and 8, in view of the barrier means 50-53 may be increased. For instance, for proper EUV transmission a xenon pressure lower than 10⁻³ mbar in the illuminator optics chamber 8 is desirable. A xenon pressure in this range leads to a transmission higher than 94% for 13.5 nm radiation.

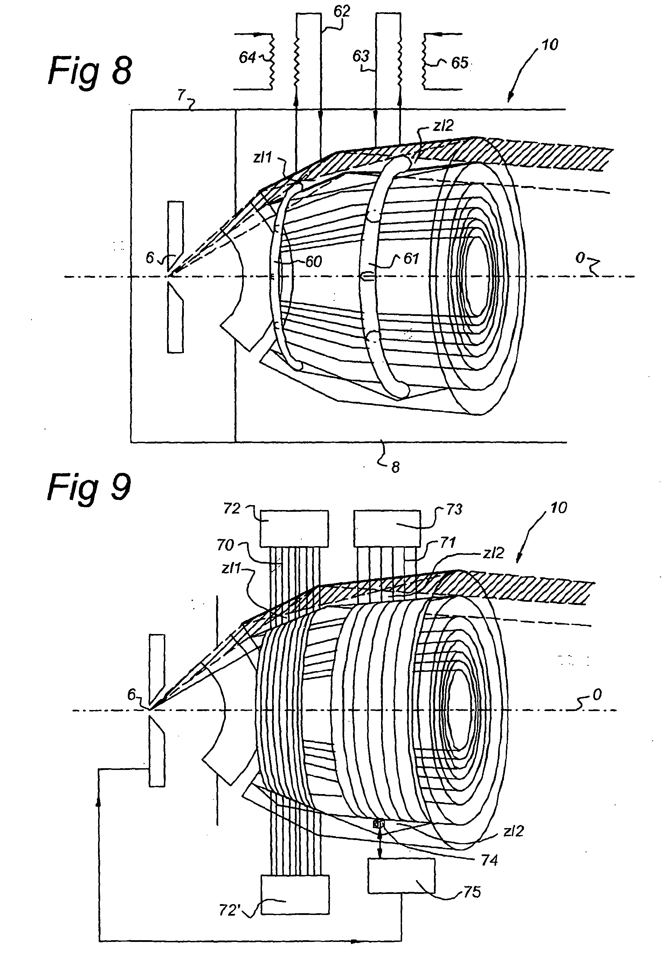

Fig. 8 shows a grazing incidence collector 10 in which in the zones of low radiation intensity z11, z12 coaxial with the optical axis, cooling tubes 60, 61 are placed supported on the backing surface of the reflectors. Within cooling tubes 60, 61 a cooling fluid is circulated in a heat exchange loop 62, 63 placed outside the illuminator optics chamber 8. After passing heat exchangers 64, 65 the cooling fluid is recirculated, Typically, more than 250 Watt of radiation generated by the source 6 will be absorbed by the grazing incidence collector 10. Temperatures of the reflector of grazing incidence collector 10 near the source 6 may rise to over 100-300 °C at a position near the radiation source 6 and to temperatures ranging from 50-150 °C at a position of the collector 10 at the distance from the source 6. By cooling the collector 10, temperatures may be reduced. By proper cooling, the temperature of the collector can reach the ambient temperature level. As a cooling fluid water may be used or a liquid metal such as Na.

In Fig. 9 a number of cooling wires 70, 71 is placed on the backing surface of the reflectors. The wires may for instance be formed by copper wires. Near the source 6, the cooling capacities of the wires 70 may be relatively large by placing the wires in close proximity along the optical axis O. At positions further along the optical axis, the cooling wires 71 may be spaced apart further to reduce the cooling properties in order to generate a cooling gradient along the optical axis. Alternatively, the diameters of the cooling wires 70, 71 may vary. The end of wires 70, 71 may be connected to a heat sink 72, 72', 73. The heat sink may be varied in cooling capacity in order to regulate the temperature of the reflectors in dependence on the power of the source. As shown in Fig. 9, a measuring unit 74 may be placed in zone of low radiation intensity z12 for supplying a measurement signal to a computing unit 75. Measuring unit 74 may for instance be thermocouple, such that for instance control of the radiation source 6, dependent on the temperature may occur via computing unit 75. Alternatively, instead of a measuring unit 74, a displacement unit can be employed, such as a piezo electric crystal for adjusting the position of the reflectors via computing unit 75 for instance in dependence on the power of the source 6 or the temperature of the reflectors.

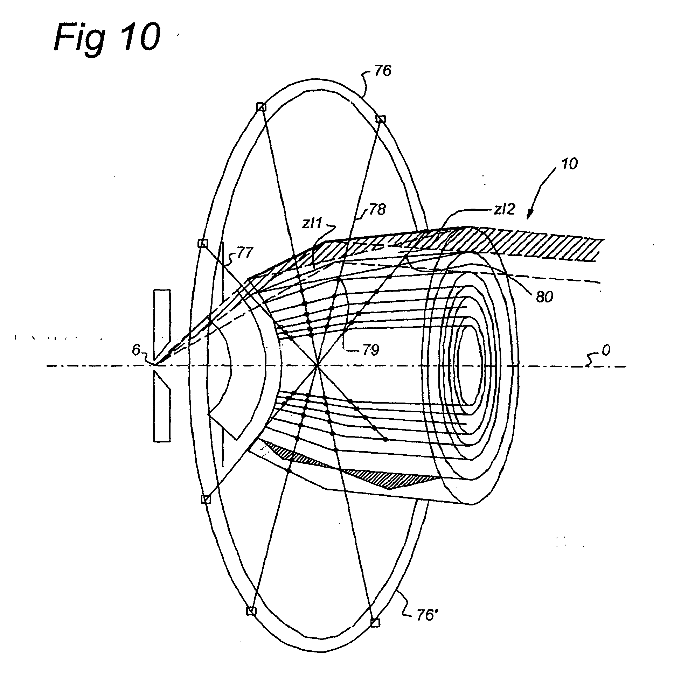

Finally, Fig. 10 shows collector support members 76,76' carrying support rods 77,78 extending through the zones of low radiation intensity z11, z12. Individual reflectors are supported on the rod 77,78 and are fixed in a accurately defined mutual relationship. The collectors are attached to the support rods 77, 78 in attachment points 79, 80 by appropriate attachment techniques such as welding or brazing. The reflectors together with the support rods 77, 78 form, when viewed parallel to the optical axis O, a "spider wheel" structure. This structure creates a shade in the rest of the system (downstream of the structure). Upstream of the "spider wheel" structure, objects can be placed in the (virtual) shade of the structure. These object will be radiated by the EUV beam. However, this will not result in less light downstream of the structure.

In the collector 10 there are low-intensity zones, and additional zones which correspond to the upstream shade of the structure. Both zones can be used for the purposes as described above. Since the upstream shades of the structure extend outside the collector, they can be used for gas inlet, cable input/output and additional support structure for transducers, gas nozzles, pumping restrictions and cooling structures.

While specific embodiments of the invention have been described above, it will be appreciated that the invention may be practiced otherwise then as described. The description is not intended to limit the invention.

## Claims

1. Reflector assembly (10) for reflecting rays of electromagnetic radiation, the reflector assembly (10) comprising at least a first reflector (21) and a second reflector (22), said first reflector (21) and said second reflector (22) being arranged symmetrically about an optical axis (O), each of said first reflector (21) and second reflector (22) having a reflective surface (26, 27) and a backing surface (24, 25), in which reflector assembly (10) an imaginary line (L) intersecting said reflectors (21, 22) and perpendicular to the optical axis (O), intersects said first reflector (21) at a first distance (r1) from the optical axis (O) and intersects said second reflector (22) at a second distance (r2) from the optical axis (O), the first distance (r1) being larger than the second distance (r2), some rays deriving from a point on the optical axis (O) being cut off by said second reflector (22) and other rays deriving from said point on the optical axis (O) being reflected on the reflective surface of the first reflector (21) defining zones of high radiation intensity (zh) and zones of low radiation intensity (zl) between said reflectors (21, 22) **characterized in that** a nozzle (37,38) for directing a fluid between the first and second reflectors (21, 22) is present on the backing surface (25) of the second reflector (22) at the position of the low intensity zone (zl).

2. Reflector assembly (10) according to claim 1, wherein said first and second reflectors (21, 22) extend at an angle (α, β) to the optical axis (O).

3. Reflector assembly (10) according to claim 2, wherein each of said first and second reflectors (21, 22) comprises a first and a second reflecting surface (32, 33), the first reflecting surface (33) being placed at a smaller angle to the optical axis (O) than the second reflecting surface (32) .

4. Reflector assembly (10) according to claim 2 or 3, wherein the first and second reflectors (21, 22) are substantially coaxial.

5. Reflector assembly (10) according to any of the preceding claim 2-4, said reflector assembly (10) having an entry side (29, 30), wherein said nozzle comprises at least one fluid supply means (35, 36) for directing a fluid in the direction of said entry side (29, 30).

6. Reflector assembly (10) according to claim 5, wherein said fluid is substantially transparent to EUV radiation with a wavelength between 5-20 nm.

7. Reflector assembly (10) according to any of the claims 5 or 6, wherein a fluid removal unit (42) is located near the entry side (29, 30) of the reflector assembly (10).

8. Reflector assembly (10) according to any of the claims 2-7 **characterized in that** said angle (α, β) varies along the optical axis (O).

9. Radiation system comprising a radiation source (6) and a reflector assembly (10) according to any of the claims 1-8.

10. A lithographic projection apparatus comprising:
- a radiation system (3, 4) to form a projection beam (6') of radiation, from radiation emitted by a radiation source (6),
- a support structure (MT) constructed to hold patterning means, to be irradiated by the projection beam to pattern said projection beam,
- a substrate table (WT) constructed to hold a substrate, and
- a projection system (5) constructed and arranged to image an irradiated portion of the patterning means onto a target portion of the substrate,
wherein said radiation system (3, 4) further comprises a reflector assembly (10) according to any one of the claims 1-8.

11. Method of manufacturing an integrated structure by a lithographic process comprising the steps of:
- providing a radiation system (3, 4) to form a projection beam (6') of radiation, from radiation emitted by a radiation source (6),
- directing rays of radiation emitted by the radiation source (6), to a reflector assembly (10) for reflecting radiation, the reflector assembly (10) comprising at least a first reflector (21) and a second reflector (22), said first reflector (21) and said second reflector (22) being arranged to reflect radiation coming from said radiation source (6) at grazing angles in a direction towards further optical components and arranged symmetrically about an optical axis (O), each of said first reflector (21) and second reflector (22) having a reflective surface (26, 27) and a backing surface (24, 25), in which reflector assembly (10) an imaginary line (L) intersecting said reflectors (21, 22) and perpendicular to the optical axis (O), intersects said first reflector (21) at a first distance (r1) from the optical axis (O) and intersects said second reflector (22) at a second distance (r2) from the optical axis (O), the first distance (r1) being larger than the second distance (r2), some rays deriving from a point on the optical axis (O) being cut off by said second reflector (22) and other rays deriving from said point on the optical axis (O) being reflected on the reflective surface of the first reflector (21) defining zones of high radiation intensity (zh) and zones of low radiation intensity (zl) between said reflectors (21, 22),
- providing a support structure (MT) constructed to hold patterning means, to be irradiated by the projection beam to pattern said projection beam,
- providing a substrate table (WT) constructed to hold a substrate, and
- providing a projection system (5) constructed and arranged to image an irradiated portion of the patterning means onto a target portion of the substrate,
**characterized in that** the method further comprises:
- placing a nozzle for directing a fluid between the first and second reflectors (21, 22) on the backing surface (25) of said second reflector (22) in said low radiation intensive region (z1).

## Patentansprüche

1. Reflektoranordnung (10) zum Reflektieren von elektromagnetischer Strahlung, wobei die Reflektoranordnung (10) mindestens einen ersten Reflektor (21) und einen zweiten Reflektor (22) aufweist, wobei der erste Reflektor (21) und der zweite Reflektor (22) symmetrisch um eine optische Achse (O) angeordnet sind, wobei der erste Reflektor (21) und der zweite Reflektor (22) jeweils eine reflektierende Oberfläche (26, 27) und eine Trägerfläche (24, 25) aufweisen, wobei in dieser Reflektoranordnung (10) eine gedachte Linie (L), welche die Reflektoren (21, 22) schneidet und zur optischen Achse (O) senkrecht steht, den ersten Reflektor (21) in einem ersten Abstand (r1) von der optischen Achse (O) schneidet und den zweiten Reflektor (22) in einem zweiten Abstand (r2) von der optischen Achse (O) schneidet, wobei der erste Abstand (r1) größer als der zweite Abstand (r2) ist, wobei einige Strahlen, die von einem Punkt auf der optischen Achse (O) stammen und von dem zweiten Reflektor (22) abgefangen werden, und andere Strahlen, die von diesem Punkt auf der optischen Achse (O) stammen und auf der reflektierenden Oberfläche des ersten Reflektors (21) reflektiert werden, Zonen (zh) einer hohen Strahlungsintensität und Zonen (zl) einer niedrigen Strahlungsintensität zwischen den Reflektoren (21, 22) definieren,
**dadurch gekennzeichnet,**
**dass** eine Düse (37, 38) zum Richten eines Fluids zwischen dem ersten und dem zweiten Reflektor (21, 22) auf der Trägerfläche (25) des zweiten Reflektors (22) in der Position der Zone (zl) einer niedrigen Intensität vorhanden ist.

2. Reflektoranordnung (10) nach Anspruch 1, wobei sich der erste und der zweite Reflektor (21, 22) in einem Winkel (α, β) zur optischen Achse (O) erstrecken.

3. Reflektoranordnung (10) nach Anspruch 2, wobei der erste und der zweite Reflektor (21, 22) jeweils eine erste und eine zweite reflektierende Oberfläche (32, 33) aufweisen, wobei die erste reflektierende Oberfläche (33) in einem kleineren Winkel zur optischen Achse (O) als die zweite reflektierende Oberfläche (32) angeordnet ist.

4. Reflektoranordnung (10) nach Anspruch 2 oder 3, wobei der erste und der zweite Reflektor (21, 22) im Wesentlichen koaxial sind.

5. Reflektoranordnung (10) nach einem der vorherigen Ansprüche 2 bis 4, wobei die Reflektoranordnung (10) eine Eintrittsseite (29, 30) aufweist, wobei die Düse mindestens eine Fluidzuführeinrichtung (35, 36) zum Richten eines Fluids in der Richtung der Eintrittsseite (29, 30) aufweist.

6. Reflektoranordnung (10) nach Anspruch 5, wobei das Fluid für EUV (Extremes UltraViolett)-Strahlung mit einer Wellenlänge zwischen 5 - 20 nm im Wesentlichen transparent ist.

7. Reflektoranordnung (10) nach einem der Ansprüche 5 oder 6, wobei sich eine Fluidabführeinheit (42) in der Nähe der Eintrittsseite (29, 30) der Reflektoranordnung (10) befindet.

8. Reflektoranordnung (10) nach einem der Ansprüche 2 bis 7, **dadurch gekennzeichnet, dass** der Winkel (α, β) entlang der optischen Achse (O) variiert.

9. Strahlungssystem, welches eine Strahlungsquelle (6) und eine Reflektoranordnung (10) nach einem der Ansprüche 1 bis 8 aufweist.

10. Lithografie-Projektionsvorrichtung, welche aufweist:
- ein Strahlungssystem (3, 4) zum Ausbilden eines Strahlungsprojektionsstrahls (6') aus einer von einer Strahlungsquelle (6) abgegebenen Strahlung,
- einen Trägeraufbau (MT), der dazu ausgelegt ist, Strukturierungseinrichtungen aufzunehmen, die mit dem Projektionsstrahl bestrahlt werden sollen, um den Projektionsstrahl zu strukturieren,
- einen Substrattisch (WT), der dazu ausgelegt ist, ein Substrat aufzunehmen, und
- ein Projektionssystem (5), das dazu ausgelegt und angeordnet ist, einen zu bestrahlenden Teil der Strukturierungseinrichtungen auf einen Ziel-Teil des Substrats abzubilden,
wobei das Strahlungssystem (3, 4) ferner eine Reflektoranordnung (10) nach einem der Ansprüche 1 bis 8 aufweist.

11. Verfahren zur Herstellung eines integrierten Aufbaus mittels eines Lithografieprozesses, wobei das Verfahren die folgenden Schritte umfasst:
- Vorsehen eines Strahlungssystems (3, 4) zum Ausbilden eines Strahlungsprojektionsstrahls (6') aus einer von einer Strahlungsquelle (6) abgegebenen Strahlung,
- Richten von Strahlen einer von der Strahlungsquelle (6) abgegebenen Strahlung auf eine Reflektoranordnung (10) zum Reflektieren von Strahlung, wobei die Reflektoranordnung (10) mindestens einen ersten Reflektor (21) und einen zweiten Reflektor (22) aufweist, der erste Reflektor (21) und der zweite Reflektor (22) so angeordnet sind, dass sie eine von der Strahlungsquelle (6) kommende Strahlung in Streifwinkeln in einer Richtung auf weitere optische Komponenten hin reflektieren, und symmetrisch um eine optische Achse (O) angeordnet sind, wobei der erste Reflektor (21) und der zweite Reflektor (22) jeweils eine reflektierende Oberfläche (26, 27) und eine Trägerfläche (24, 25) aufweisen, wobei in dieser Reflektoranordnung (10) eine gedachte Linie (L), welche die Reflektoren (21, 22) schneidet und senkrecht zu der optischen Achse (O) steht, den ersten Reflektor (21) in einem ersten Abstand (r1) von der optischen Achse (O) schneidet und den zweiten Reflektor (22) in einem zweiten Abstand (r2) von der optischen Achse (O) schneidet, wobei der erste Abstand (r1) größer als der zweite Abstand (r2) ist, wobei einige Strahlen, die von einem Punkt auf der optischen Achse (O) stammen und von dem zweiten Reflektor (22) abgefangen werden, und andere Strahlen, die von diesem Punkt auf der optischen Achse (O) stammen und auf der reflektierenden Oberfläche des ersten Reflektors (21) reflektiert werden, Zonen (zh) einer hohen Strahlungsintensität und Zonen (zl) einer niedrigen Strahlungsintensität zwischen den Reflektoren (21, 22) definieren,
- Vorsehen eines Trägeraufbaus (MT), der dazu ausgelegt ist, Strukturierungseinrichtungen aufzunehmen, die von dem Projektionsstrahl bestrahlt werden sollen, um den Projektionsstrahl zu strukturieren,
- Vorsehen eines Substrattisches (WT), der dazu ausgelegt ist, ein Substrat aufzunehmen, und
- Vorsehen eines Projektionssystems (5), das dazu ausgelegt und angeordnet ist, einen zu bestrahlenden Teil der Strukturierungseinrichtungen auf einen Target-Teil des Substrats abzubilden,
**dadurch gekennzeichnet, dass** das Verfahren ferner umfasst:
- Anordnen einer Düse zum Richten eines Fluids zwischen dem ersten und dem zweiten Reflektor (21, 22) auf der Trägerfläche (25) des zweiten Reflektors (22) in dem Bereich (zl) einer niedrigen Strahlungsintensität.

## Revendications

1. Ensemble à réflecteurs (10) destiné à réfléchir des rayons d'un rayonnement électromagnétique, l'ensemble à réflecteurs (10) comportant au moins un premier réflecteur (21) et un second réflecteur (22), ledit premier réflecteur (21) et ledit second réflecteur (22) étant agencés symétriquement par rapport à un axe optique (O), chacun dudit premier réflecteur (21) et dudit second réflecteur (22) ayant une surface réfléchissante (26, 27) et une surface dorsale (24, 25), ensemble à réflecteur (10) dans lequel une ligne imaginaire (L) intersectant lesdits réflecteurs (21, 22) et perpendiculaire à l'axe optique (O) intersecte ledit premier réflecteur (21) à une première distance (r1) de l'axe optique (O) et intersecte ledit second réflecteur (22) à une seconde distance (r2) de l'axe optique (O), la première distance (r1) étant supérieure à la seconde distance (r2), certains rayons provenant d'un point situé sur l'axe optique (O) étant coupés par ledit second réflecteur (22) et d'autres rayons provenant dudit point sur l'axe optique (O) étant réfléchis sur la surface réfléchissante du premier réflecteur (21) définissant des zones d'intensité de rayonnement élevée (zh) et des zones d'intensité de rayonnement basse (zl) entre lesdits réflecteurs (21, 22), **caractérisé en ce qu'**une buse (37, 38) destinée à diriger un fluide entre les premier et second réflecteurs (21, 22) est présente sur la surface dorsale (25) du second réflecteur (22) dans la position de la zone de basse intensité (zl).

2. Ensemble à réflecteurs (10) selon la revendication 1, dans lequel lesdits premier et second réflecteurs (21, 22) forment un angle (α, β) avec l'axe optique (O).

3. Ensemble à réflecteurs (10) selon la revendication 2, dans lequel chacun desdits premier et second réflecteurs (21, 22) comporte des première et seconde surfaces réfléchissantes (32, 33), la première surface réfléchissante (33) étant placée de façon à former un angle plus petit que celui de la seconde surface réfléchissante (32) avec l'axe optique (O).

4. Ensemble à réflecteurs (10) selon la revendication 2 ou 3, dans lequel les premier et second réflecteurs (21, 22) sont sensiblement coaxiaux.

5. Ensemble à réflecteurs (10) selon l'une quelconque des revendications 2 à 4, ledit ensemble à réflecteurs (10) ayant un côté d'entrée (29, 30), dans lequel ladite buse comporte au moins un moyen (35, 36) d'alimentation en fluide destiné à diriger un fluide dans la direction du côté d'entrée (29, 30).

6. Ensemble à réflecteurs (10) selon la revendication 5, dans lequel ledit fluide est sensiblement transparent à un rayonnement EUV d'une longueur d'onde comprise entre 5 et 20 nm.

7. Ensemble à réflecteurs (10) selon l'une quelconque des revendications 5 et 6, dans lequel une unité (42) d'élimination de fluide est placée à proximité du côté d'entrée (29, 30) de l'ensemble à réflecteurs (10).

8. Ensemble à réflecteurs (10) selon l'une quelconque des revendications 2 à 7, **caractérisé en ce que** ledit angle (α, β) varie le long de l'axe optique (O).

9. Système de rayonnement comportant une source de rayonnement (6) et un ensemble à réflecteurs (10) selon l'une quelconque des revendications 1 à 8.

10. Appareil de projection lithographique comportant :
- un système de rayonnement (3, 4) pour former un faisceau (6') de projection d'un rayonnement, à partir d'un rayonnement émis par une source de rayonnement (6),
- une structure de support (MT) construite de façon à porter un moyen de formation de motif, devant être irradié par le faisceau de projection pour façonner suivant un motif ledit faisceau de projection,
- une table (WT) de substrat construite de façon à porter un substrat, et
- un système de projection (5) construit et agencé de façon à former une image d'une partie irradiée du moyen de formation de motif sur une partie cible du substrat,
dans lequel ledit système de rayonnement (3, 4) comporte en outre un ensemble à réflecteurs (10) selon l'une quelconque des revendications 1 à 8.

11. Procédé de fabrication d'une structure intégrée par un processus lithographique, comprenant les étapes qui consistent à :
- utiliser un système de rayonnement (3, 4) pour former un faisceau de projection (6') d'un rayonnement, à partir d'un rayonnement émis par une source de rayonnement (6),
- diriger des rayons du rayonnement émis par la source de rayonnement (6) sur un ensemble à réflecteurs (10) pour réfléchir le rayonnement, l'ensemble à réflecteurs (10) comportant au moins un premier réflecteur (21) et un second réflecteur (22), ledit premier réflecteur (21) et ledit second réflecteur (22) étant agencés de façon à réfléchir un rayonnement arrivant de ladite source de rayonnement (6) à des angles d'incidence rasante dans une direction tournée vers d'autres constituants optiques et agencés symétriquement par rapport à un axe optique (O), chacun dudit premier réflecteur (21) et dudit second réflecteur (22) ayant une surface réfléchissante (26, 27) et une surface dorsale (24, 25), ensemble à réflecteurs (10) dans lequel une ligne imaginaire (L) intersectant lesdits réflecteurs (21, 22) et perpendiculaire à l'axe optique (O) intersecte ledit premier réflecteur (21) à une première distance (r1) de l'axe optique (O) et intersecte ledit second réflecteur (22) à une seconde distance (r2) de l'axe optique (O), la première distance (r1) étant supérieure à la seconde distance (r2), certains rayons provenant d'un point situé sur l'axe optique (O) étant coupés par ledit second réflecteur (22) et d'autres rayons provenant dudit point sur l'axe optique (O) étant réfléchis sur la surface réfléchissante du premier réflecteur (21) définissant des zones d'intensité de rayonnement élevée (zh) et des zones d'intensité de rayonnement basse (zl) entre lesdits réflecteurs (21, 22),
- utiliser une structure de support (MT) construite pour porter un moyen de formation de motif, devant être irradié par le faisceau de projection pour façonner suivant un motif ledit faisceau de projection,
- utiliser une table (WT) de substrat construite de façon à porter un substrat, et
- utiliser un système de projection (5) construit et agencé pour former une image d'une partie irradiée du moyen de formation de motif sur une partie cible du substrat,
le procédé étant **caractérisé en ce qu'**il comprend en outre :
- la mise en place d'une buse destinée à diriger un fluide entre les premier et second réflecteurs (21, 22) sur la surface dorsale (25) dudit second réflecteur (22) dans ladite région d'intensité de rayonnement basse (zl).
